# EUROPÄISCHE PATENTSCHRIFT

(11) **EP 0 304 902 B1**
(45) Veröffentlichungstag und Bekanntmachung des Hinweises auf die Patenterteilung: **18.11.1993**
(21) Anmeldenummer: 88113814.3
(22) Anmeldetag: 24.08.1988
(51) Int. Cl.: H05K 3/22

(54) **Anordnung zum Ändern und/oder Reparieren von Flachbaugruppen bei Bestückung mit SMD-Bausteinen**
Arrangement for modifying and/or repairing a flat module when inserting surface-mounted components
Dispositif utilisé pour la modification et/ou la réparation des voies conductrices portées par un panneau comportant des composants montés en surface

(30) Priorität: 28.08.1987 DE 8711698 U
(43) Veröffentlichungstag der Anmeldung: 01.03.1989
(73) Patentinhaber: Siemens Nixdorf Informationssysteme Aktiengesellschaft, 33102 Paderborn (DE)
(72) Erfinder: Schall, Hans, D-8031 Eichenau (DE); Nagel, Günter, Ing. grad., D-8016 Heimstetten (DE)
(74) Vertreter: Fuchs, Franz-Josef, Dr.-Ing.

(56) Entgegenhaltungen:
- DE-A- 1 814 690
- DE-U- 8 711 698
- US-A- 4 438 561
- US-A- 4 631 820
- GALVANOTECHNIK, Band 72, Nr. 6, Juni 1981, Seiten 688-689, Saulgau, DE; K. LINDNER: "Die Reparatur gedruckter Schaltungen"

## Beschreibung

Bei Fertigung von Multi-Layer-Leiterplatten (mit 2 bis z.B. 22 einzelnen Lagen) treten trotz aller Vorsichtsmaßnahmen immer wieder Fehler in Form von Unterbrechungen oder Einschnürungen der geätzten Leiterbahnen auf. Auch Fehler in den durchkontaktierten Bohrungen sind sporadisch zu verzeichnen. Bei Fehlern dieser Art ist ein Verwurf der Baugruppen aus Kosten-oder Termingründen in der Regel kaum möglich oder zweckmäßig, so daß eine einfache Reparaturmöglichkeit erforderlich ist. Nach der mit bedrahteten Bausteinen üblicherweise durchgeführten Reparaturmethode wurde in der Regel die unterbrochene Leitung durch einen Draht ersetzt, der auf die Lötflecken der Leiterplatte aufgelötet wurde.

Ferner kann es bei fertiggestellten Flachbaugruppen erforderlich sein, logische Änderungen in den auf den Leiterplatten realisierten Schaltungen schnell durchführen zu können. Dazu wird heute üblicherweise die nicht mehr benötigte geätzte Leiterbahn der Leiterplatte mechanisch getrennt und die neue Verbindung mit Hilfe eines Drahtes hergestellt.

Diese Verfahren sind aber bei Verwendung der im Zuge der fortschreitenden Miniaturisierung und Automatisierung in verstärktem Maße eingesetzten sogenannten SMD-Bausteine (Surface-Mounted-Device) nicht anwendbar, da nach Plazierung der Bausteine auf der Leiterplatte die jeweils verbleibende Restfläche auf den Lötflecken für das Auflöten von Änderungs- oder Reparaturdrähten zu gering ist. Bekannt geworden ist deshalb, bei Flat-Pack-Gehäusen das jeweils betroffene Beinchen abzulöten und hochzubiegen und den neuen Verbindungsdraht direkt an dem hochgebogenen Beinchen anzulöten. Diese Methode hat den Nachteil der schwierigen Mechanisierbarkeit und der meist sehr schwierigen Drahtführung auf der Bauteilseite der Flachbaugruppe.

Um diese Nachteile zu vermeiden hat man statt dessen die Anschlußflecken der SMD-Bauteile auf der Leiterplatte größer gemacht und trennbar ausgeführt. Diese Methode hat jedoch den Nachteil des größeren Platzbedarfes für das SMD-Bauteil und des Verlustes von Durchkontaktierungen auf der Leiterplatte.

Der Erfindung lag daher die Aufgabe zugrunde, eine Anordnung zu schaffen, mit deren Hilfe Änderungen und/oder Reparaturen an Leiterplatten auch dann durchgeführt werden können, wenn diese mit sogenannten SMD-oder ähnlichen Bausteinen bestückt sind.

Erfindungsgemäß wird dies erreicht durch einen als Miniaturleiterplatte ausgebildeten, mindestens zwei nebeneinander liegende Lötflecken bzw. den jeweiligen Baustein seitlich überragenden Zwischenträger, auf dem ein Ersatz- und /oder Änderungsbaustein bzw. Reparatur- und/oder Änderungsdrähte angeordnet werden können. Durch die Tatsache, daß der als Miniaturleiterplatte ausgebildete Zwischenträger mindestens zwei nebeneinander liegende Lötflecken bzw. den jeweiligen Baustein seitlich überragt, ist auf diesem ausreichend Platz vorhanden, um einen Ersatz-und/oder Änderungsbaustein bzw. Änderungs- und/oder Reparaturdrähte anzuordnen. Die erfindungsgemäße Anordnung hat ferner den Vorteil, daß der Ersatz- und/oder Änderungsbaustein bzw. die Reparatur- und/oder Änderungsdrähte nicht genau an derjenigen Stelle angebracht werden müssen, wo die Änderung bzw. Reparatur vorzunehmen ist. Der Zwischenträger kann vielmehr weitgehend beliebig auf der Flachbaugruppe plaziert werden so daß im Rahmen der zulässigen Drahtlängen freie Stellen auf der Leiterplatte genutzt werden können. Bei genügend freiem Raum können auch mehrere Zwischenträger nebeneinander angeordnet werden.

Um den Zwischenträger auf der Flachbaugruppe sicher anbringen zu können, ist es vorteilhaft, eine seiner Flächen mit einer Kleberschicht zu versehen.

Im einfachsten Fall ist der Zwischenträger einlagig ausgebildet. Für Änderungszwecke kann es aber auch zweckmäßig sein, die Miniaturleiterplatte des Zwischenträgers mehrlagig auszugestalten.

Um die erfindungsgemäße Anordnung rationell fertigen und weiterverarbeiten zu können, sieht eine vorteilhafte Weiterbildung der Erfindung vor, eine Vielzahl von Zwischenträgern nebeneinanderliegend in einer kupferkaschierten Platte auszubilden und insbesondere jeden Zwischenträger nur über zwei als Sollbruchstellen dienende schmale Stege mit der Platte zu verbinden. Eine besonders rationelle Fertigung der erfindungsgemäßen Anordnung erreicht man, wenn die Zwischenträger in der kupferkaschierten Platte so angeordnet sind, daß sie alle vor dem Heraustrennen mit den gewünschten Ersatz- und/oder Änderungsbausteinen bzw. Änderungs- und/oder Reparaturdrähten bestückt werden können.

Weitere Einzelheiten der Erfindung ergeben sich aus der nachfolgenden Beschreibung einiger Ausführungsbeispiele anhand der FIG 1 bis 1 bis 5, wobei
- FIG 1: einen Ausschnitt aus einer Leiterplatte mit einer Darstellung von Lötflecken und SMD-Baustein zeigt,
- FIG 2: eine erfindungsgemäße Anordnung in Draufsicht und Seitenansicht wiedergibt,
- FIG 3: die Plazierung einer erfindungsgemäßen Anordnung auf einer Flachbaugruppe zeigt, und die
- FIG 4 und FIG 5: die erfindungsgemäße Anordnung während der Herstellung im Nutzen erkennen lassen.

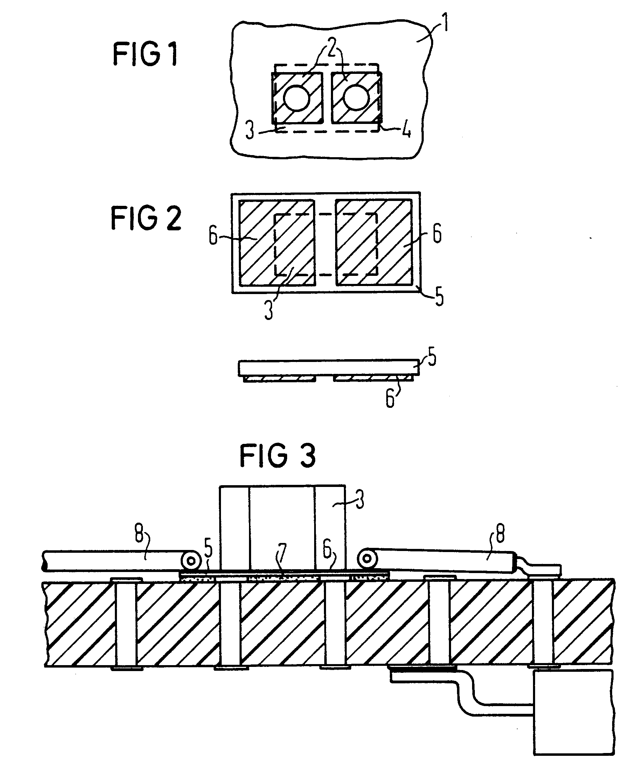

FIG 1 zeigt einen Ausschnitt aus einer Leiterplatte 1 mit zwei als schraffierte Flächen dargestellten Lötflecken 2. Mit gestrichelten Linien angedeutet ist ein SMD-Baustein 3, der, wie zu erkennen ist, nach seiner Montage auf den Lötflecken 2 an deren Rand nur ganz schmale Streifen 4 übrig läßt. Diese Streifen 4 können je nach Größe des SMD-Bausteines sogar zu Null werden, das heißt verschwinden.

Um bei dieser Sachlage eine Möglichkeit zum Anbringen von Ersatz- und/oder Änderungsbausteinen bzw. Änderungs- und/oder Reparaturdrähten zu schaffen, ist erfindungsgemäß ein Zwischenträger 5 vorgesehen, wie ihn FIG 2 zeigt, der als Miniatur-Leiterplatte ausgebildet ist. Im Beispiel von FIG 2 wird dies dadurch erreicht, daß auf dem Zwischenträger 5 zwei Lötflecken 6 vorgesehen sind. Wie angedeutet, ragt der Zwischenträger 5 seitlich über mindestens zwei nebeneinander liegende Lötflecken 2 bzw. die Länge und Breite des Bausteines 3 hinaus und ermöglicht so die Anordnung von Änderungs- und /oder Reparadrähten neben dem Baustein 3.

Wenn gemäß einer vorteilhaften Weiterbildung der erfindungsgemäßen Anordnung eine Fläche des Zwischenträgers 5 mit einer Kleberschicht 7 versehen ist, so kann der Zwischenträger, wie in FIG 3 gezeigt ist, an einer beliebigen Stelle auf der Leiterplatte 1 plaziert und durch die Kleberschicht 7 befestigt werden.

FIG 3 zeigt ferner, wie der SMD-Baustein 3 auf den Lötflecken 6 des Zwischenträgers 5 angeordnet und neben dem Baustein 3 auf den Lötflecken 6 noch Platz für den Anschluß von Änderungsund /oder Reparaturdrähten 8 vorhanden ist. Sie zeigt außerdem, wie der Zwischenträger 5 an einer freien Stelle der Flachbaugruppe plaziert und die Enden der Änderungs- und/oder Reparaturdrähte 8 zu den gewünschten Lötflekken der Leiterplatte geführt werden können.

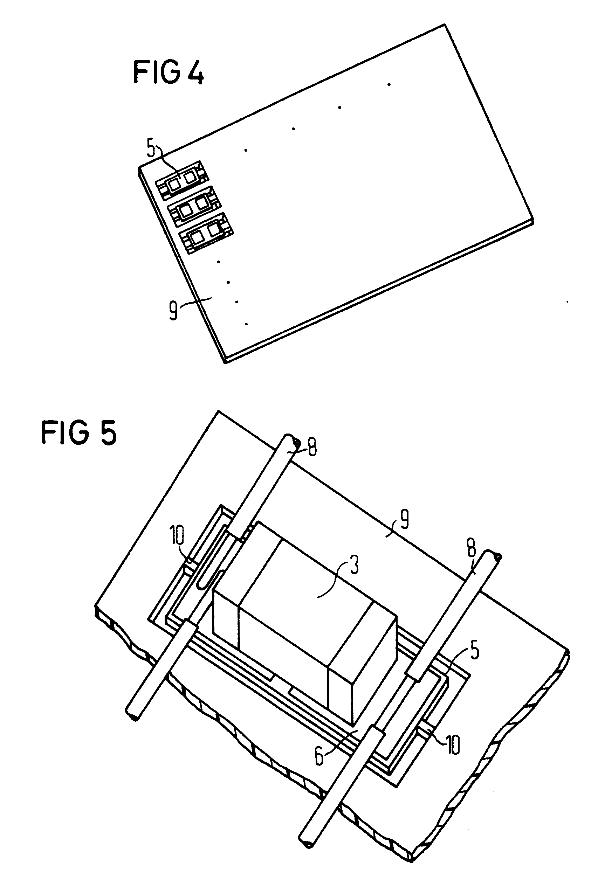

Um die einzelnen Zwischenträger 5 rationell fertigen und weiterverarbeiten zu können, ist es zweckmäßig, diese in einem Nutzen mit einer Vielzahl von Zwischenträgern herzustellen. FIG 4 zeigt hierfür ein Beispiel und insbesondere, wie eine Vielzahl von Zwischenträgern 5 nebeneinander liegend in einer kupferkaschierten Platte 9 gebildet ist.

Wie FIG 5 detailliert zeigt, ist es besonders zweckmäßig, dabei die Zwischenträger 5 nur über zwei als Sollbruchstellen dienende schmale Stege 10 mit dem Rest der kupferkaschierten Platte 9 in Verbindung stehen zu lassen. Wenn außerdem die Zwischenträger 5 in der kupferkaschierten Platte 9 so angeordnet werden, daß sie alle vor dem Heraustrennen mit den gewünschten Ersatz- und/oder Änderungsbausteinen 3 bzw. Änderungs- und/oder Reparaturdrähten 8 - vorzugsweise maschinell - bestückt werden können, so kann nach Fertigstellung des ganzen Nutzens je nach Bedarf der entsprechend komplett bestückte Zwischenträger durch Herausbrechen an den Sollbruchstellen 10 aus dem Nutzen 9 entfernt und auf der jeweiligen Flachbaugruppe plaziert werden.

## Patentansprüche

1. Anordnung, bestehend aus Flachbaugruppen und einer Vorrichtung zum Ändern und/oder Reparieren von Flachbaugruppen, wobei die als mehrlagigen Leiterplatten gebildeten Flachbaugruppen mit Bausteinen, insbesondere mit sogenannten SMD-Bausteinen, bestückt sind, die in Bezug auf die Lötflecken der Leiterplatte so groß sind, daß ein Anlöten von Änderungs- und/oder Reparaturdrähten an den Lötflecken nicht möglich ist, **gekennzeichnet durch** einen als Miniaturleiterplatte (5) ausgebildeten, mindestens zwei nebeneinanderliegende Lötflecken (2) bzw. den mit diesen Lötflecken (2) elektrisch zu verbindenden Baustein (3) seitlich überragenden Zwischenträger, auf dem ein Ersatz- und/oder Änderungsbaustein (3) bzw. Änderungs- und/oder Reparaturdrähte (8) angeordnet werden können.

2. Anordnung nach Anspruch 1,
**dadurch gekennzeichnet,** daß der Zwischenträger (5) mindestens eine der Anzahl der Bausteinanschlüsse enstprechende Anzahl von Lötflecken (6) besitzt.

3. Anordnung nach Anspruch 1 oder 2,
**dadurch gekennzeichnet,** daß die eine Fläche des Zwischenträgers (5) mit einer Kleber-Schicht (7) versehen ist.

4. Anordnung nach einem der Ansprüche 1 bis 3,
**dadurch gekennzeichnet,** daß die Miniatur-Leiterplatte des Zwischenträgers (5) einlagig ausgebildet ist.

5. Anordnung nach einem der Ansprüche 1 bis 3,
**dadurch gekennzeichnet,** daß die Miniatur-Leiterplatte des Zwischenträgers (5) mehrlagig ausgebildet ist.

6. Anordnung nach einem der Ansprüche 1 bis 5,
**dadurch gekennzeichnet,** daß zur rationellen Fertigung und Verarbeitung eine Vielzahl von Zwischenträgern (5) nebeneinanderliegend in einer kupferkaschierten Platte (9) gebildet sind.

7. Anordnung nach Anspruch 6,
**dadurch gekennzeichnet,** daß jeder Zwischenträger (5) nur über zwei als Soll-Bruchstellen dienende schmale Stege (10) mit dem Rest der kupferkaschierten Platte (9) verbunden ist.

8. Anordnung nach Anspruch 6 oder 7,
**dadurch gekennzeichnet,** daß die Zwischenträger (5) in der kupferkaschierten Platte (9) so angeordnet sind, daß sie alle vor dem Heraustrennen mit den gewünschten Ersatz- und/oder Änderungsbausteinen (3) bzw. Änderungs- und/oder Reparaturdrähten (8) maschinell bestückt werden können.

## Claims

1. Arrangement consisting of flat modules and a device for modifying and/or repairing flat modules, the flat modules, formed as multi-layer circuit boards, being equipped with chips, particularly with so-called SMD chips which are of such a size with respect to the soldering spots of the circuit board that it is not possible to solder modification and/or repair wires to the soldering spots, characterized by an intermediate carrier which is constructed as miniature circuit board (5) and laterally protrudes over at least two adjacently located soldering spots (2) or the chip (3) electrically to be connected to these soldering spots (2), on which intermediate carrier a replacement and/or modification chip (3) or modification and/or repair wires (8) can be arranged.

2. Arrangement according to Claim 1, characterised in that the intermediate carrier (5) has at least a number of soldering spots (6) corresponding to the number of chip terminals.

3. Arrangement according to Claim 1 or 2, characterised in that one surface of the intermediate carrier (5) is provided with an adhesive layer (7).

4. Arrangement according to one of Claims 1 to 3, characterised in that the miniature circuit board of the intermediate carrier (5) is constructed as a single layer.

5. Arrangement according to one of Claims 1 to 3, characterised in that the miniature circuit board of the intermediate carrier (5) is constructed to be multi-layered.

6. Arrangement according to one of Claims 1 to 5, characterised in that a multiplicity of intermediate carriers (5) are formed adjacently to one another in a copper-clad board (9) for the purpose of efficient production and processing.

7. Arrangement according to Claim 6, characterised in that each intermediate carrier (5) is only connected to the remainder of the copper-clad board (9) via two narrow webs (10) used as design breaking points.

8. Arrangement according to Claim 6 or 7, characterised in that the intermediate carriers (5) are arranged in the copper-clad board (9) in such a manner that they can all be equipped by machine with the required replacement and/or modification chips (3) or modification and/or repair wires (8) before they are separated out.

## Revendications

1. Agencement constitué par des modules plats et par un dispositif pour modifier et/ou réparer des modules plats, les modules plats réalisés sous la forme de plaquettes à circuits imprimés à couches multiples étant pourvus de composants, notamment de ce qu'on appelle des composants SMD, qui présentent une taille si importante par rapport aux plages de brasage de la plaquette à circuits imprimés qu'un brasage de fils de modification et/ou de réparation n'est pas possible sur les plages de brasage, caractérisé par un support intermédiaire qui est réalisé sous la forme d'une plaquette à circuits imprimés miniature (5) et fait saillie latéralement au-delà d'au moins deux plages de brasage disposées côte-à-côte ou du composant (3) devant être raccordé électriquement à ces plages de brasage (2) et sur lequel peuvent être disposés un composant de remplacement et/ou de modification (3) ou des fils de modification et/ou de réparation (8).

2. Agencement suivant la revendication 1, caractérisé par le fait que le support intermédiaire (5) possède au moins un nombre de plages de brasage (6) qui correspond au nombre des bornes des composants.

3. Agencement suivant la revendication 1 ou 2, caractérisé par le fait qu'une surface du support intermédiaire (5) est recouverte d'une couche de colle (7).

4. Agencement suivant l'une des revendications 1 à 3, caractérisé par le fait que la plaquette à circuits imprimés miniature du support intermédiaire (5) est réalisée avec une seule couche.

5. Agencement suivant l'une des revendications 1 à 3, caractérisé par le fait que la plaquette à circuits imprimés miniature du support intermédiaire (5) est réalisée avec plusieurs couches.

6. Agencement suivant l'une des revendications 1 à 5, caractérisé par le fait que pour la fabrication et le traitement rationnels, une multiplicité de supports intermédiaires (5) sont formés côte-à-côte dans une plaque (9) recouverte d'un placage en cuivre.

7. Agencement suivant la revendication 6, caractérisé par le fait que chaque support intermédiaire (5) est raccordé au reste de la plaque (9) recouverte d'un placage en cuivre, uniquement par l'intermédiaire de deux barrettes étroites (10) utilisées comme points de rupture imposée.

8. Agencement suivant la revendication 6 ou 7, caractérisé par le fait que les supports intermédiaires (5) sont disposés dans la plaque (9) recouverte d'un placage en cuivre de telle sorte qu'ils peuvent tous être équipés mécaniquement, avant leur séparation, avec les composants de remplacement et/ou de modification (3) désirés ou avec les fils de modification et/ou de réparation (8) désirés.
